# EUROPEAN PATENT APPLICATION

(11) **EP 4 803 896 A1**
(43) Date of publication of application: **09.09.2026**
(21) Application number: 26162483.7
(22) Date of filing: 05.03.2026
(51) Int. Cl.: G01N 27/90, G01B 7/16, H05K 1/16

(54) **CONFORMABLE SENSOR ASSEMBLY AND SYSTEM**

(30) Priority: 07.03.2025 US 202563768278 P
(71) Applicant: General Electric Company, Cincinnati, Ohio 45215 (US)
(72) Inventor: TRIVEDI, Deepak, Niskayuna, 12309-1027 (US); KOYITHITTA MEETHAL, Manoj Kumar, 560066 Bengaluru (IN); SHEILA VADDE, Aparna Chakrapani, 560066 Bengaluru (IN); PAVINATTO, Felippe Jose, Niskayuna, 12309-1027 (US); KRISHNAMURTHY, Sriram, 560066 Bengaluru (IN)
(74) Representative: Openshaw & Co.

(57) **Abstract**

A sensor assembly (100) may include at least one stretchable layer (102) including a stretchable substrate (103) having a modulus of less than about 5 megapascals (MPa) and an elongation of break of greater than about 25 percent about at least one axis, and at least one flexible layer (104) including a flexible substrate (105) having an elongation of break of greater than about 10 percent about at least one axis, the at least one flexible layer (104) having a plurality of cuts (106, 206) formed therein. The sensor assembly (100) may include an actuation layer (116) including at least one contact pressure actuator (118) for adjusting contact pressure of a target surface (154) on the sensor assembly (100).

## Description

### CROSS-REFERENCE TO RELATED APPLICATIONS

This application claims the benefit of priority of U.S. Provisional Application No. 63/768,278 filed March 7, 2025, which is herein incorporated by reference in its entirety.

### TECHNICAL FIELD

These teachings relate generally to sensor systems and more particularly to conformable sensor systems.

### BACKGROUND

Composite and metal structures with complex geometries (e.g., curved surfaces) can be difficult to inspect. Traditional inspection methods often involve contact between a sensor and the component being inspected. However, the inspection of components with complex geometries (e.g., a gas turbine engine) can be difficult due to the lack of conformability of many traditional sensors. Accordingly, it may be desirable to have a sensor system capable of conforming to complex geometries.

### BRIEF DESCRIPTION OF DRAWINGS

Various needs are at least partially met through provision of the conformable sensor systems described in the following detailed description, particularly when studied in conjunction with the drawings. A full and enabling disclosure of the aspects of the present description, including the best mode thereof, directed to one of ordinary skill in the art, is set forth in the specification, which refers to the appended figures, in which:
FIG. 1A is a top schematic view of a sensor assembly as configured in accordance with various embodiments of these teachings;
FIG. 1B is a side schematic view of the sensor assembly of FIG. 1A as configured in accordance with various embodiments of these teachings;
FIG. 2 is a top schematic view of a portion of the sensor assembly of FIGS. 1A and 1B as configured in accordance with various embodiments of these teachings;
FIG. 3 is a top schematic view of a portion of the sensor assembly of FIGS. 1A and 1B as configured in accordance with various embodiments of these teachings;
FIG. 4 is a top schematic view of a portion of the sensor assembly of FIGS. 1A and 1B as configured in accordance with various embodiments of these teachings;
FIG. 5 is a block diagram of a sensor assembly as configured in accordance with various embodiments of these teachings;
FIG. 6 is a block diagram of a portion of a sensor assembly as configured in accordance with various embodiments of these teachings;
FIG. 7 is a block diagram showing conformability features that can be implemented in a sensor assembly, according to various embodiments; and
FIGS. 8A, 8B, 8C, 8D, 8E, 8F, 8G, 8H, 8I, 8J, and 8K are top schematic views of a portion of the sensor assembly with alternative conformability feature configurations, in accordance with various embodiments of these teachings.

Elements in the figures are illustrated for simplicity and clarity and have not necessarily been drawn to scale. For example, the dimensions and/or relative positioning of some of the elements in the figures may be exaggerated relative to other elements to help to improve understanding of various embodiments of the present teachings. Also, common but well-understood elements that are useful or necessary in a commercially feasible embodiment are often not depicted in order to facilitate a less obstructed view of these various embodiments of the present teachings. Certain actions and/or steps may be described or depicted in a particular order of occurrence while those skilled in the art will understand that such specificity with respect to sequence is not actually required.

### DETAILED DESCRIPTION

Composite and metal structures with complex geometries (e.g., bi-axial or multi-axial curvature) can be difficult to inspect. Traditional methods like ultrasound, eddy current, or impedance sensing generally involve conformal contact between the sensor and the surface being inspected. Flexible sensors generally bend in only one dimension. Stretchable sensors typically lack adequate trace density that meets sensing requirements because it is difficult to print high density traces on stretchable substrates. These are all significant challenges in the context of the inspection of multi-axially curved components, such as aerospace components.

Generally speaking, the present disclosure provides a sensor assembly that includes at least one stretchable layer and at least one flexible layer. The at least one stretchable layer includes a stretchable substrate. The at least one flexible layer includes a flexible substrate with multiple cuts formed therein. The flexible layer(s) include high-pitch traces and one or more cuts to achieve multi-axial conformity. In some aspects, the sensor assembly includes an actuation layer with a stretchable substrate and one or more contact pressure actuators. The actuator(s) utilize feedback from the sensor assembly to improve or optimize contact pressure. The sensor assembly described herein provides high-resolution sensing capabilities for multi-axially curved surfaces by using traces for pressure sensing, target inspection, and packaging.

As used herein, "flexible" refers to a material with the ability to bend, stretch, or deform without breaking. In some examples, the material may elongate at a break of greater than or equal to 10%. In other words, the material may be elongated to more than 110% of the original length before failure.

As used herein, "stretchable" refers to a material with a modulus less than or equal to 60 megapascals (MPa) and the ability to bend, stretch, or deform without breaking. In some examples, the material may stretch at a break of greater than or equal to 25%. In other words, the material may be stretched to more than 125% of the original length before failure. In some examples, stretchable may refer to a material with a modulus of between 5 and 20 MPa.

As used herein, "trace" may refer to a sensor element used to conduct signals throughout one or more sensor layers. In some examples, the trace may include one or more coils, such as drive coils that generate a magnetic field which induce eddy currents in a target material when an alternating current (AC) passes through the coil, sense coils that sense or detect the response of the magnetic field caused by eddy currents, or combinations thereof.

As used herein, the term "pitch" may refer to a gap or spacing between adjacent portions of a trace. Pitch may also be referred to as trace spacing or trace resolution.

As used herein, the term "high pitch" may generally refer to traces having a pitch or trace spacing that is greater than about 50 micrometers (µm). High pitch may also be referred to as high resolution.

As used herein, the term "low pitch" may generally refer to traces having a pitch or trace spacing that is less than or equal to about 50 micrometers (µm). Low pitch may also be referred to as low resolution.

The terms and expressions used herein have the ordinary technical meaning as is accorded to such terms and expressions by persons skilled in the technical field as set forth above except where different specific meanings have otherwise been set forth herein. The word "or" when used herein shall be interpreted as having a disjunctive construction rather than a conjunctive construction unless otherwise specifically indicated. The terms "coupled," "fixed," "attached to," and the like refer to both direct coupling, fixing, or attaching, as well as indirect coupling, fixing, or attaching through one or more intermediate components or features, unless otherwise specified herein.

The singular forms "a", "an", and "the" include plural references unless the context clearly dictates otherwise.

Approximating language, as used herein throughout the specification and claims, is applied to modify any quantitative representation that could permissibly vary without resulting in a change in the basic function to which it is related. Accordingly, a value modified by a term or terms such as "about", "approximately", and "substantially", are not to be limited to the precise value specified. In at least some instances, the approximating language may correspond to the precision of an instrument for measuring the value, or the precision of the methods or machines for constructing or manufacturing the components and/or systems. For example, the approximating language may refer to being within a 10 percent margin.

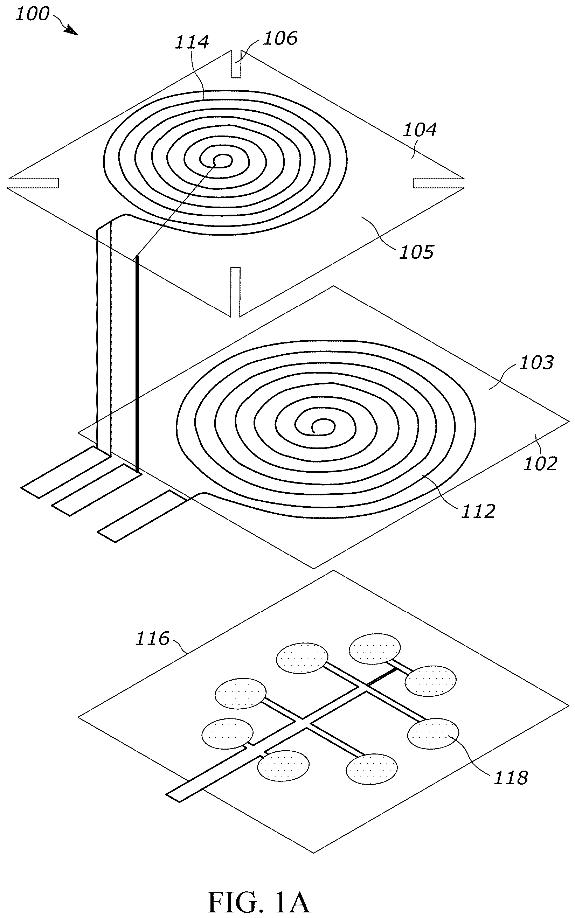

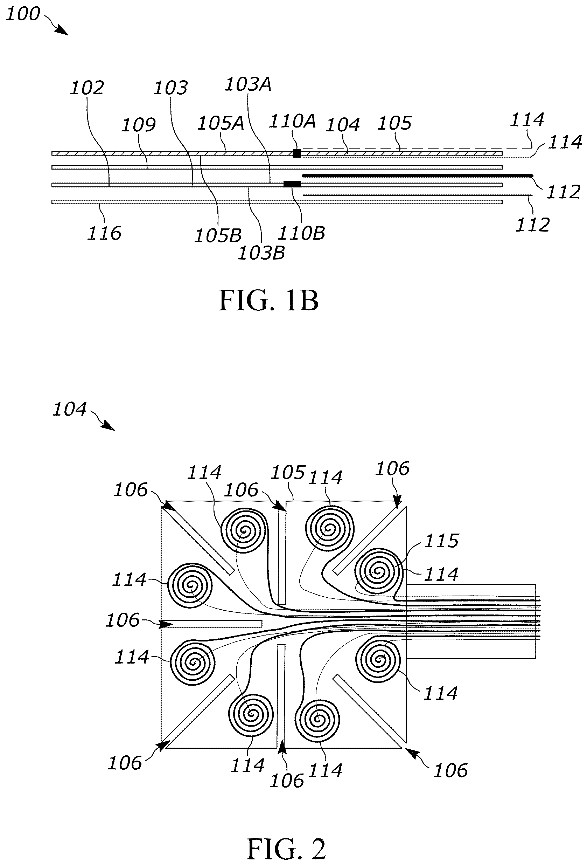

Referring now to the drawings, FIG. 1A shows a sensor assembly 100, in accordance with some embodiments. The sensor assembly 100 is a multi-layer assembly that includes at least one stretchable layer 102, at least one flexible layer 104, and, in some embodiments, at least one actuation layer 116. The stretchable layer 102 can conform to target surfaces with multi-axial curvatures. The flexible layer 104 can incorporate high-pitch traces for high resolution sensing. The combination of the flexible layer 104 and the stretchable layer 102 results in a sensor assembly that can conform to a target surface while also providing the resolution needed for inspection. The sensor assembly 100 includes a plurality of sensor elements, such as traces, disposed on the various layers to provide conductive pathways for electrical circuits in the sensor assembly 100. FIGS. 1A and 1B show the sensor assembly 100 in an assembled configuration. FIGS. 2-4 illustrate the individual layers of the sensor assembly in further detail.

The flexible layer 104 includes a flexible substrate 105 that is able to bend about at least one axis. The flexible layer 104 includes a first group of sensor elements 114 that are printed on the flexible substrate 105. Sensor elements in the first group of sensor elements 114 can include traces, coils (e.g., drive coils, sense coils), etc. The first group of sensor elements 114 can include a single sensor element (e.g., a single coil) or an array of sensor elements (e.g., an array of coils). In some embodiments, the first group of sensor elements 114 includes one or more coils. In some embodiments, the coils in the first group of sensor elements 114 are sense coils. The flexible layer 104 further includes a conformability feature that comprises a plurality of cuts 106 formed in the flexible substrate 105. The plurality of cuts 106 help the flexibly layer 104 to conform, for example, when the sensor assembly 100 is bent or stretched during use. The inclusion of cuts 106 or notches in the flexible substrate 105 enables the sensor assembly 100 to conform, for example, to fit around curves as the stretchable layer 102 deforms to conform to a target surface being inspected. Cuts 106 can be strategically placed to allow the flexible layer 104 to conform with the stretchable layer 102, for example, as the stretchable layer 102 adapts with the target surface being inspected. Edges of the cuts 106 may allow for the flexible substrate 105 to fold or overlap to fit around curves on the target surface. The flexible layer 104 is shown and described in further detail with reference to FIG. 2.

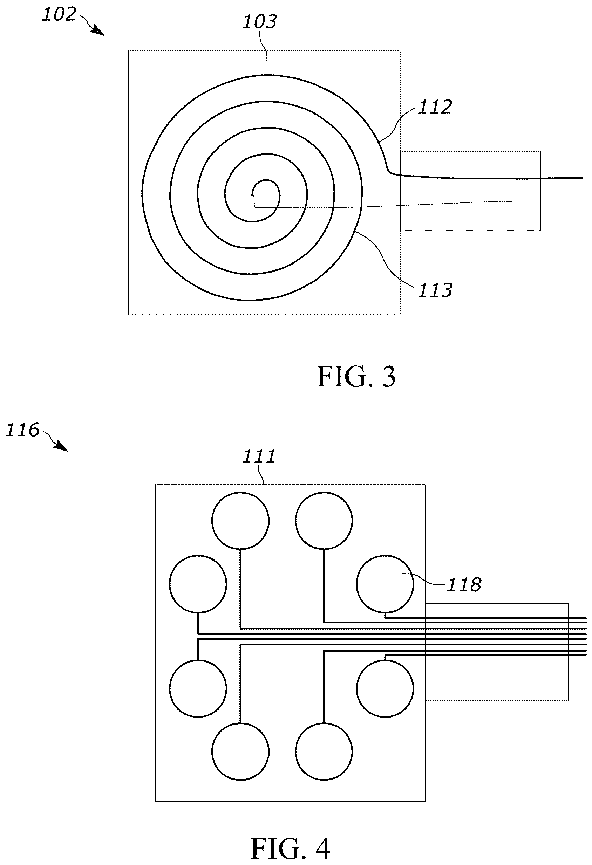

The stretchable layer 102 includes a stretchable substrate 103 that is able to bend about multiple, for example, at least two, axes. The stretchable layer 102 includes a second group of sensor elements 112 that are printed on the stretchable substrate 103. Sensor elements in the second group of sensor elements 112 can include traces, coils (e.g., drive coils, sense coils), etc. The second group of sensor elements 112 can include a single sensor element (e.g., a single coil) or an array of sensor elements (e.g., an array of coils). In some embodiments, the second group of sensor elements 112 includes one or more coils. In some embodiments, the coil in the second group of sensor elements 112 is a drive coil that is configured to generate the magnetic field that is excited and induces eddy currents in the component (e.g., a conductive material) being tested. The stretchable layer 102 is shown and described in further detail with reference to FIG. 3.

The actuation layer 116 includes a stretchable substrate with at least one contact pressure actuator 118 disposed thereon for adjusting a contact pressure between the sensor assembly 100 and a target surface being inspected. The contact pressure actuators 118 may be operated to ensure consistent contact pressure. FIG. 4 illustrates the actuation layer 116 in further detail.

In some aspects, the dimensions (e.g., thickness, length, width, and so forth) of the various layers of the sensor assembly 100 are the same, while in some aspects, the dimensions of the layers of the sensor assembly 100 may vary from layer to layer. The layers of the sensor assembly 100 may be configured in any suitable number (e.g., three layers, four layers, etc.), configuration (e.g., stacked, side-by-side, separated, and/or a combination thereof), and/or type of layer (e.g., flexible, stretchable, actuation, stiff, overlay, and so forth).

In some embodiments, the sensor assembly 100 is a conformable sensor that is able to conform to the geometry of a component being inspected.

In some embodiments, the sensor assembly 100 is a rollable sensor that can be rolled and unrolled to conform to an inspection surface. In one example, the sensor assembly 100 may be able to be rolled for insertion into a difficult to access inspection location, such as through an inspection port in an engine, and unrolled for inspection. In another example, the sensor assembly 100 may be able to be rolled for storage and unrolled for use in an inspection.

In some aspects, the sensor assembly 100 is in the form of a printed circuit board, and the layers comprising the sensor assembly 100 can be layers of the printed circuit board. It is generally contemplated that in alternate approaches, multi-transducer ultrasonic testing and/or computed tomography scans may be used for inspection of components having complex geometries.

FIG. 1B is a side view of the sensor assembly 100 of FIG. 1A, illustrating an exemplary arrangement of the layers of the sensor assembly 100. The flexible layer 104, the stretchable layer 102, and the actuation layer 116 are coupled together in a stacked configuration. The sensor elements 112, 114 (e.g., traces) are disposed between the substrates 103, 105 of the various layers 104, 102, 116. The sensor assembly 100 includes vias 110A, 110B to create electrical connections between the various layers. In some configurations, at least a portion of the sensor elements 114 (e.g., sense coils) on the flexible layer 104 are overlapping with sensor elements 112 (e.g., drive coils) on the stretchable layer 102. In some configurations, the sensor elements 114 on the flexible layer 104 are offset from the sensor elements 112 on the stretchable layer 102. In some configurations, the sensor elements 114 on the flexible layer 104 surround (e.g., are arranged around a periphery) of the sensor elements 112 on the stretchable layer 102.

As shown in FIG. 1B, the flexible layer 104 is disposed on a first or top side of the sensor assembly 100. The actuation layer 116 is disposed on a second or bottom side of the sensor assembly 100, the second or bottom side being opposite the first or top side. The stretchable layer 102 is positioned between the flexible layer 104 and the actuation layer 116. An intermediate layer 109 that is formed from a stretchable or a flexible substrate is positioned between the flexible layer 104 and the stretchable layer 102. In this example, the term "top" may refer to a side of the sensor assembly 100 that will not contact a target surface of a component being inspected and also refers to sides of layers facing the "top". The term "bottom" may refer to a side of the sensor assembly 100 opposite the "top" that will contact the target surface of the component being inspected. Arranging the sensor assembly 100 such that the flexible layer 104 is on the top and the stretchable layer 102 is at or near the bottom allows the sensor assembly 100 to bend downwardly towards the component being inspected. It is to be understood that the flexible layer 104, the stretchable layer 102, and the actuation layer 116 can be arranged in any alternate manner. For example, the flexible layer(s) 104 may be on top of, below, between, etc., the stretchable layer(s) 102.

The first group of sensor elements 114 on the flexible layer 104 includes double-sided traces with traces on a first side 105A and a second side 105B of the flexible substrate 105. The first side 105A of the flexible substrate 105 is positioned opposite the second side 105B. In some configurations, the first side 105A of the flexible substrate 105 is a topmost side and the second side 105B is a bottommost side.

The second group of sensor elements 112 on the stretchable layer 102 also includes double-sided traces with traces on a first side 103A and a second side 103B of the stretchable substrate 103. The first side 103A of the stretchable substrate 103 is positioned opposite the second side 103B. In some configurations, the first side 103A of the stretchable substrate 103 is a topmost side and the second side 103B is a bottommost side.

The first group of sensor elements 114 and the second group of sensor elements 112 form a plurality of sensor elements. At least some of the plurality of elements are disposed between the plurality of cuts 106 in the flexible layer 104. In some embodiments, at least some of the traces in the first group of sensor elements 114 are disposed between the plurality of cuts 106.

The flexible layer 104 includes a first via 110A and the stretchable layer 102 includes a second via 110B. The first via 110A is formed in the flexible substrate 105. The first via 110A creates an electrical connection between the flexible layer 104 and the intermediate layer 109. The first via 110A also electrically connects traces of the first group of sensor elements 114 on the first side 105A and the second side 105B of the flexible substrate 105. The second via 110B is formed in the stretchable substrate 103 of the stretchable layer 102. The second via 110B creates an electrical connection between the stretchable layer 102 and the actuation layer 116. The second via 110B also electrically connects traces of the second group of sensor elements 112 on the first side 103A and the second side 103B of the stretchable substrate 103. The first via 110A and the second via 110B can be formed using any suitable technique, for example, using a drilling process or a chemical etching process. The sensor assembly 100 may include any suitable number of vias to establish electrical connections.

In some embodiments, the actuation layer 116 is an outermost layer of the sensor assembly. So configured, the actuation layer 116 encapsulates the sensor assembly 100 and protects the traces (e.g., the second group of sensor elements 112) from the external environment. In some embodiments, the actuation layer 116 is the layer of the sensor assembly 100 which contacts a target surface of the component being inspected.

In some aspects, there may be one or more thin adhesive layers within the sensor assembly 100. For example, adhesive layers may be disposed between flexible layers 104 and/or stretchable layers 102 to adhere the layers together. Examples of suitable adhesives may include pressure sensitive adhesives (PSA) such as polyurethane-based adhesives, etc. In some aspects, an adhesive layer may have a thickness in the range of about 5 µm to about 40 µm, about 5 µm to about 15 µm, or in some aspects, about 10 µm to about 15 µm. In some aspects, an adhesive is selected that is suitable for fabrication of the sensor assembly 100.

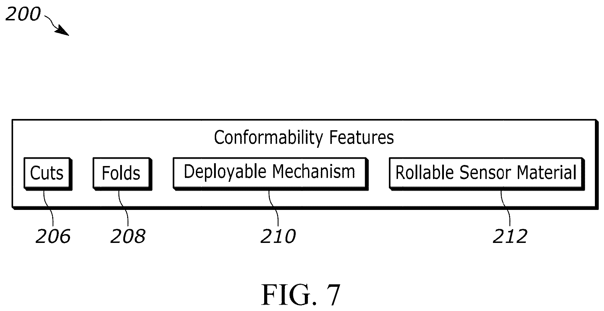

FIG. 2 shows the flexible layer 104 of the sensor assembly 100, according to some embodiments. In the embodiment of FIG. 2, the flexible layer 104 is shown with a plurality of sensor elements 114 whereas the embodiment of FIG. 1A and FIG. 1B depicts the flexible layer 104 with a single sensor element 114. The flexible layer 104 includes the flexible substrate 105 with the first group of sensor elements 114 formed thereon. As illustrated, the first group of sensor elements 114 includes eight sensor elements 114, however, it is contemplated that any suitable the first group of sensor elements 114 can include any suitable number of sensor elements 114 and even a single sensor element 114, as is shown in the embodiment of FIG. 1A and FIG. 1B. The first group of sensor elements 114 can be in the form of one or more coils, though other suitable sensor element configurations may be used. In some aspects, the sensor elements 114 include one or more sense coils that are configured to detect changes in the magnetic field (e.g., by measuring changes in impedance of the sense coils) caused by eddy currents induced in the component being tested. Sense coils may measure a response from the component, for example, perturbations of eddy currents in the component due to defects or properties of the component. In some embodiments, the first group of sensor elements 114 includes high pitch traces. Elements in the first group of sensor elements 114 can be made of any suitable electrically conductive material including but not limited to gold, silver, and copper. The flexible layer 104 also includes a conformability feature. In the illustrated embodiment, the conformability feature is the plurality of cuts 106. It is contemplated that the flexible layer 104 may incorporate alternative or additional conformability features. FIG. 7 shows additional conformability features that can be implemented in the flexible layer 104 according to various embodiments.

In some embodiments, the flexible substrate 105 has an elongation of break of greater than about 10 percent about at least one axis. By one approach, the flexible layer 104 does not have a modulus requirement and is consequently unable to increase in length but may bend. In other words, the flexible layer 104 may be a strain limiting layer that will flex but not stretch. The flexible substrate 105 can be formed from any suitable material having an elongation of break greater than about 10 percent about at least one axis. Suitable materials for the flexible substrate 105 include but are not limited to polyethylene terephthalate (PET), polycarbonate (PC), polyethylene naphthalene (PEN), polyethylene (PE), polypropylene (PP), and polyimide (Kapton^{®}). In some embodiments, the flexible layer 104 has a thickness in the range of about 10 micrometers (µm) to about 100 µm, 10 µm to about 50 µm, about 20 µm to about 40 µm, or, in some aspects, about 30 µm to about 40 µm, or, in some aspects, about 20 µm to about 30 µm.

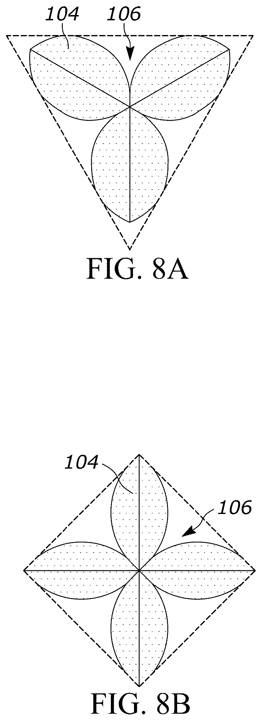

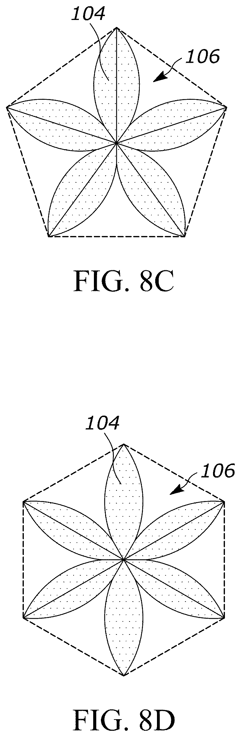

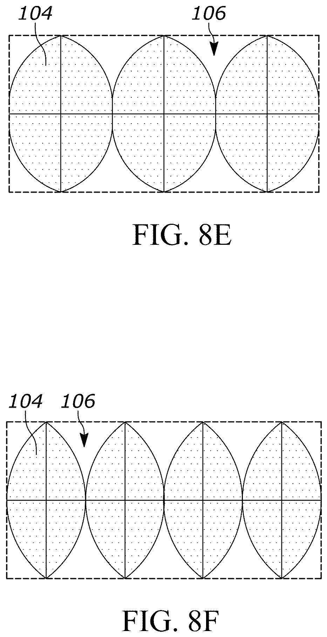

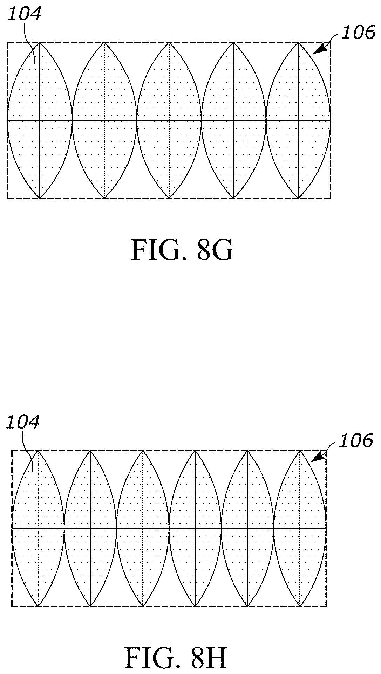

In the illustrated embodiment, the plurality of cuts 106 are radial cuts that extend inward from an edge of the flexible substrate 105 towards a center of the flexible substrate 105. The plurality of cuts 106 includes seven linear cuts disposed along the edges of the flexible substrate 105. The plurality of cuts enable the sensor assembly 100 to flex and conform to multiaxially-curved surfaces. It is contemplated that any alternate configuration and/or shape may be used for the plurality of cuts 106. The plurality of cuts 106 can be formed in any suitable manner, including but not limited to, via a laser. FIGS. 8A-8K illustrate alternative configurations for the plurality of cuts 106 in the flexible layer 104.

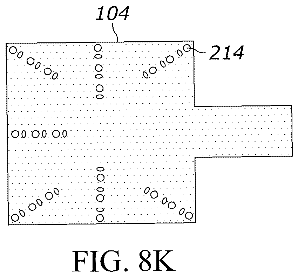

In some embodiments, groupings of holes can be included in place of the plurality of cuts 106. FIG. 8K illustrates an exemplary configuration where the flexible layer 104 includes groupings of holes. The holes may be formed, for example, using a drilling process. In some approaches, the holes may be formed using the same process used to form vias in one or more layers of the sensor assembly 100.

Further, in some alternative embodiments, the plurality of cuts 106 or other conformability features can be formed or included in an overlay layer (not shown in FIG. 2) of the sensor assembly 100, rather than in the flexible layer 104. In yet other embodiments, the plurality of cuts 106 or other conformability features can be formed or included in one or more stretchable layers and/or in the actuation layer 116 of the sensor assembly 100. For example, the plurality of cuts 106 can be formed in one or more of the stretchable layer 102 and the intermediate layer 109.

In some embodiments, the first group of sensor elements 114 includes traces formed from an active material. The active material can be a shape memory alloy, however, it is generally contemplated that alternate suitable active materials may be used. Such traces may be configured for sensing and pressure actuation in accordance with some embodiments. In some embodiments, when the first group of sensor elements 114 is made from a shape memory alloy, the actuation layer 116 is omitted. In some embodiments, the sensor assembly 100 may include both a shape memory alloy in the first group of sensor elements 114 and the actuation layer 116. In some embodiments, the first group of sensor elements 114 may include traces made from a shape memory alloy in addition to the actuation layer 116. For example, the traces formed from the shape memory alloy may provide rough positioning and the actuation layer 116 may provide fine tuning for positioning. So configured, the timing and activation of the traces formed from the shape memory alloy and the actuation layer 116 are independent of each other.

In some embodiments, an amount of current in the shape memory sensor element (e.g., a shape memory trace) will indicate an amount or level of deformation, and depending on the amount or level of deformation, the response amplitude by the shape memory alloy will increase. By monitoring the gradient and as the response signal saturates, the current flow in the shape memory trace is stabilized. Once the conformability is accomplished, either the sensor probe or the part being inspected can be moved to scan or inspect the part without making further changes in current through the sensor element (e.g., the traces).

In some embodiments, the shape memory alloy includes at least one of a Nitinol (e.g., nickel titanium) or a copper-based shape memory alloy. The shape memory alloy can deform as it receives energy and, accordingly, can perform a dual function of sensing and actuation to apply contact pressure between the sensor assembly 100 and a target surface being inspected. Generally, during inspection of a multi-dimensional object, contact pressure is desirable to conform the sensor assembly 100 to the target surface of the component being inspected.

FIG. 3 shows the stretchable layer 102 of the sensor assembly 100, according to some embodiments. The stretchable layer 102 of the sensor assembly 100 includes the stretchable substrate 103 with the second group of sensor elements 112 formed thereon. The second group of sensor elements 112 can include one or more coils and, in some aspects, includes one or more drive coils 113. Elements in the second group of sensor elements 112 can be made of any suitable electrically conductive material including but not limited to gold, silver, and copper. In some embodiments, the second group of sensor elements 112 includes low pitch traces. It is generally contemplated that the stretchable layer 102 has a low modulus so the stretchable layer 102 can easily deform when subjected to stress or strain, resulting in a low resistance to deformation and allowing the stretchable layer 102 to conform to a target surface to be inspected.

In some embodiments, the stretchable substrate 103 has a modulus of less than about 60 megapascals (MPa) and an elongation of break of greater than about 25 percent about at least one axis. The stretchable substrate 103 may be stretchable along at least one axis. The stretchable substrate 103 can be formed from any suitable material having a modulus of less than about 60 megapascals (MPa) and an elongation of break of greater than about 25 percent about at least one axis. Suitable materials for the stretchable substrate 103 include but are not limited to thermoplastic polyurethanes, silicones (e.g., PDMS, etc.), and styrene-ethylene-butylene-styrene (SEBS). In some embodiments, the stretchable layer 102 has a thickness in the range of about 10 µm to about 100 µm, 10 µm to about 50 µm, about 20 µm to about 40 µm, about 30 µm to about 40 µm, or, in some aspects, about 20 µm to about 30 µm.

In some embodiments, the second group of sensor elements 112 includes traces formed from an active material. The active material can be a shape memory alloy, however, it is generally contemplated that alternate suitable active materials may be used. Such traces may be configured for sensing and pressure actuation in accordance with some embodiments. In some embodiments, when traces in the second group of sensor elements 112 are made from a shape memory alloy, the actuation layer 116 is omitted. In some embodiments, the sensor assembly 100 may include both shape memory alloy traces in the second group of sensor elements 112 and the actuation layer 116. In some embodiments, the second group of sensor elements 112 may include traces made from a shape memory alloy in addition to the actuation layer 116. For example, the traces formed from the shape memory alloy may provide rough positioning and the actuation layer 116 may provide fine tuning for positioning. So configured, the timing and activation of the traces formed from the shape memory alloy and the actuation layer 116 are independent of each other.

In some embodiments, the shape memory alloy includes at least one of a Nitinol (e.g., nickel titanium) or a copper-based shape memory alloy. The shape memory alloy can deform as it receives energy and, accordingly, can perform a dual function of sensing and actuation to apply contact pressure between the sensor assembly 100 and a target surface being inspected. Generally, during inspection of a multi-dimensional object, contact pressure is desirable to conform the sensor assembly 100 to the target surface of the component being inspected.

FIG. 4 shows the actuation layer 116 of the sensor assembly 100, according to some embodiments. The actuation layer 116 includes one or more contact pressure actuators 118 disposed on a stretchable substrate 111. Examples of suitable contact pressure actuators 118 include microfluidics, a pneumatic array, a shape memory actuator, a multiplexed dielectric elastomer actuator, an electroactive polymer, a suction cup array, an electroadhesive pad, and a vacuum suction device. In some embodiments, signal quality feedback is used to adjust the contact pressure actuators 118 which are configured to maintain uniform contact pressure with the surface being inspected. In some aspects, contact pressure actuators 118 are configured to adjust contact pressure based on signal quality of the sensor assembly 100. In other aspects the contact pressure actuators 118 are configured to adjust contact pressure independent of signal quality, for example, to maintain a target contact pressure or contact pressure distribution.

In some forms, the contact pressure actuators 118 are shape memory actuators. In such an implementation, shape memory alloys (SMA) are used to perform pressure actuation, and the traces and structures of the contact pressure actuators 118 may have any suitable shape to facilitate pressure actuation. The actuation layer 116 would be actively actuated by the contact pressure actuators 118 . The shape memory actuators can be any element and/or trace made of shape memory alloys to apply contact pressure over the other layers (e.g., layers with sensing coils) and help position the layers over the parts under test.

In some embodiments, the contact pressure actuators 118 are in the form of fluidic chambers and lines which provide a fluid (e.g., liquid or gas) to the fluidic chambers. Inflation of the fluidic chambers, for example, as the fluidic chambers are filled with fluid, stretches the stretchable substrate 103 and cause the respective stretchable layer 102 to stretch/bend until the stretchable layer 102 touches a target surface being inspected. In such an embodiment, a pressure regulator can control fluid pressure to each chamber which may thereby control contract pressure of the sensor assembly 100 against the target surface.

As discussed above, in some embodiments, the actuation layer 116 may be omitted from the sensor assembly 100 and, instead, contact pressure actuation may be accomplished by forming traces from active materials, such as shape memory alloys, on the stretchable layer 102.

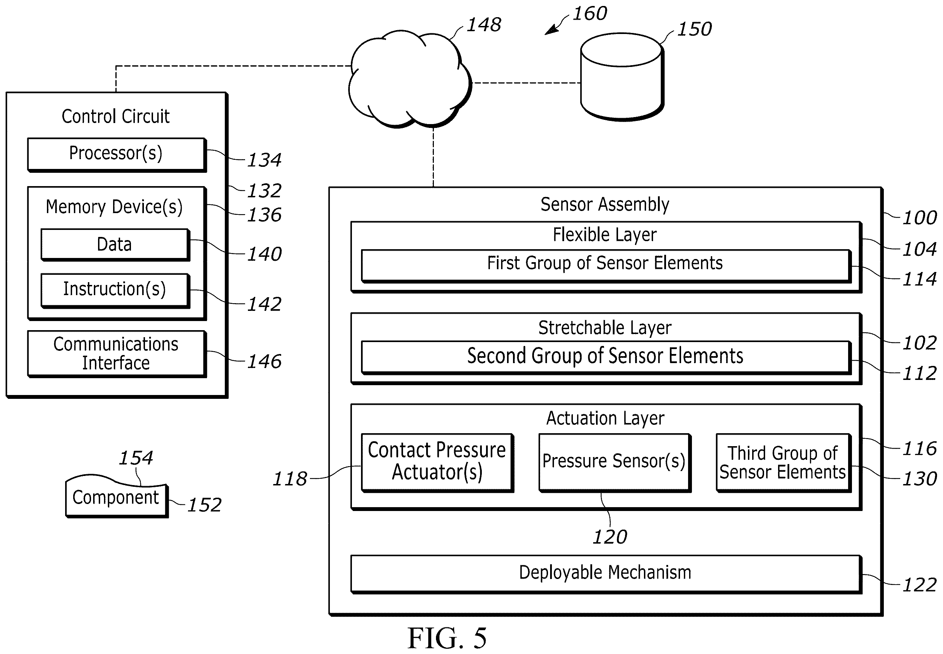

FIG. 5 shows a system 160 that includes the sensor assembly 100 that is shown and described with reference to FIGS. 1A-4. The sensor assembly 100 can be used to inspect a target surface 154 of a component 152. The target surface 154 may have a complex geometry (e.g., multiple curvatures). The sensor assembly 100 can advantageously conform to such a surface having complex geometry. The system 160 further includes a control circuit 132 and can also optionally include one or more databases 150.

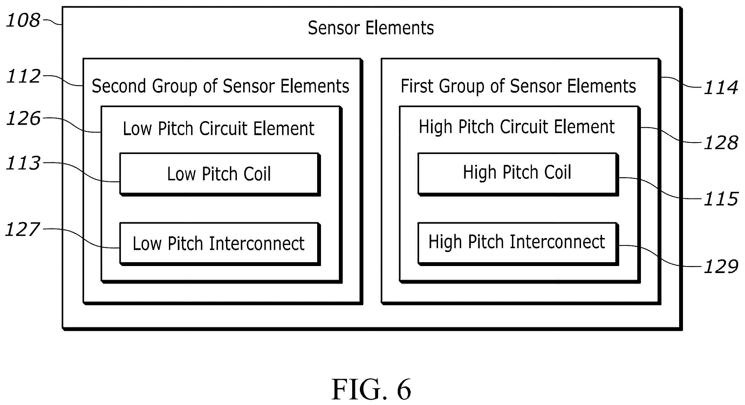

As described above, the sensor assembly 100 includes the flexible layer 104, the stretchable layer 102, and the actuation layer 116. The flexible layer 104 includes the first group of sensor elements 114. The stretchable layer 102 includes the second group of sensor elements 112. The first group of sensor elements 114 and the second group of sensor elements 112 form a plurality of sensor elements 108. An exemplary configuration of the plurality of sensor elements 108 is shown in FIG. 6. It is to be understood that the plurality of sensor elements 108, however, may include other sensor elements that are not shown in FIGS. 5 or 6.

The actuation layer 116 includes the contact pressure actuator(s) 118. The actuation layer 116 includes a third group of sensor elements 130 to provide electrical connectivity to the contact pressure actuator(s) 118 and any other sensor elements present on the actuation layer 116.

In some embodiments, the sensor assembly 100 also includes one or more pressure sensors 120 for sensing or detecting a contact pressure between the sensor assembly 100 and the target surface 154. In some embodiments, the pressure sensor(s) 120 are coupled to the actuation layer 116. However, it is contemplated that the pressure sensor(s) 120 can be coupled to the sensor assembly 100 in any suitable manner, for example, such that they are able to sense the contact pressure between the sensor assembly 100 and the target surface 154. For example, the pressure sensor(s) 120 may be arranged on the sensor assembly 100 such that the pressure sensor(s) 120 contact or are positioned adjacent to the target surface 154 during an inspection.

One or more of the first group of sensor elements 114, the second group of sensor elements 112, the contact pressure actuator(s) 118, the pressure sensor(s) 120, and the third group of sensor elements 130 can be in communication with the control circuit 132. As such, the control circuit 132 may be configured to receive data from or transmit data to one or more of these components. Further, the control circuit 132 may be able to control one or more operating parameters of these components, such as the contact pressure actuator(s) 118 and the deployable mechanism 122.

In some embodiments, the sensor assembly 100 also includes a deployable mechanism 122 that is configured to deploy the sensor assembly 100 to conform to the target surface 154. In some approaches, the deployable mechanism 122 includes one or more mechanical devices that can fold and/or unfold the sensor assembly 100 (e.g., similarly to an umbrella) which may assist with deployment of the sensor assembly 100, for example, in difficult to access locations. For example, if the component 152 is a component of gas turbine engine, the sensor assembly 100 may be compacted when inserted through an inspection port of the engine to access the component. The sensor assembly 100 can then be unfolded using the deployable mechanism 122 to inspect the component 152.

In one example, the deployable mechanism 122 includes a central rod with a runner that is slideable along the rod. One or more stretchers extend radially from the runner to the sensor assembly 100 and are coupled to the sensor assembly such that moving the runner up and down the rod moves the sensor assembly 100 between a folded and unfolded position. In another example, the deployable mechanism 122 includes one or more actuatable hinges, such as spring hinges or shape memory polymer hinges (e.g., that may be actuated by an external stimulus such as heat). In this manner, the hinge can be actuated to fold the sensor assembly 100 into a compact form for a deployment operation and then actuated again to unfold the sensor assembly 100 once the sensor assembly 100 has been deployed at a desired location. In yet another example, the deployable mechanism 122 includes one or more folds formed in the sensor assembly 100 in combination with pull-tabs that extend from the sensor assembly 100. In this manner, the sensor assembly 100 may be folded/collapsed along the folds to form a compact shape for a deployment operation and then be unfolded by pulling on the pull-tabs to return the sensor assembly 100 to a generally flat position once the sensor assembly 100 has be placed in a desired location.

One or more components of the sensor assembly 100 can be in communication with the control circuit 132. So configured, the control circuit 132 can receive data or information from various components of the sensor assembly 100 and can also adjust one or more operational parameters of various components.

In one example, the control circuit 132 is configured to perform a sensing or inspection function. In the sensing or inspection function, the control circuit 132 may receive data from one or more of the first group of sensor elements 114 and the second group of sensor elements 112. In one configuration, the second group of sensor elements 112 includes a drive coil configured to generate a magnetic field when current flows through and the first group of sensor elements 114 includes a sense coil configured to detect a change in the magnetic field. In such a configuration, the control circuit 132 may be configured to receive data indicative of the change in the magnetic field of the sense coil. In some configurations, the second group of sensor elements 112 includes the sense coil and the first group of sensor elements 114 includes the drive coil. In some configurations, the second group of sensor elements 112 and/or the first group of sensor elements 114 include both drive and sense coils. The control circuit 132 may be further configured to adjust the flow of current through the drive coil to adjust the magnetic field that is generated. In some examples, the control circuit 132 is configured to perform both a sensing and a contact pressure regulation function by being further configured to operate contact pressure actuators 118.

In one example, the control circuit 132 is operatively coupled to the contact pressure actuator(s) 118 of the actuation layer 116. Accordingly, the control circuit 132 may operate the contact pressure actuator(s) 118 and control one or more operating parameters of the contact pressure actuators such as the contact pressure between the sensor assembly 100 and the target surface 154. For example, when the contact pressure actuator(s) 118 are microfluidic channels, the control circuit 132 may adjust one or more regulators associated with the microfluidic channels to adjust the flow of liquid and, thereby, the contact pressure between the sensor assembly 100 and the target surface 154.

In another example, the control circuit 132 may receive data indicative of the signal quality of the sensor assembly 100 from the traces in the sensor assembly 100 (e.g., from the first group of sensor elements 114). The control circuit 132 may be configured to adjust the contact pressure between the sensor assembly 100 and the target surface 154 using the contact pressure actuator(s) 118 based on the signal quality from the first group of sensor elements 114 and/or the second group of sensor elements 112. With an increase in contact pressure, an electrical signal response from the first group of sensor elements 114 and/or the second group of sensor elements 112 may be expected to increase and saturate. Once saturation is achieved, in some approaches, the control circuit 132 may cause no more contact pressure to be applied by the contact pressure actuator(s) 118. In one example, the amplitude of the signal from the first group of sensor elements 114 and/or the second group of sensor elements 112 is used to adjust the contact pressure applied using the contact pressure actuator(s) 118. For example, the control circuit 132 may be configured to operate the contact pressure actuator(s) 118 to keep the amplitude of one or more signals from the first group of sensor elements 114 and/or the second group of sensor elements 112 within a range or threshold.

In some examples, the control circuit 132 may receive data indicative of the contact pressure between the sensor assembly 100 and the target surface 154 from the pressure sensor(s) 120 in the actuation layer 116. The control circuit 132 may be configured to adjust the contact pressure between the sensor assembly 100 and the target surface 154 using the contact pressure actuator(s) 118 based on the contact pressure detected by the pressure sensor(s) 120.

In some examples, the second group of sensor elements 112 can include a drive coil configured to generate a magnetic field when current flows through and the first group of sensor elements 114 can include a sense coil configured to detect a change in the magnetic field. The control circuit 132 may be configured to receive data indicative of the change in the magnetic field from the sense coil, to receive data indicative of the contact pressure from the at least one pressure sensor 120, and to adjust the contact pressure via the at least one contact pressure actuator.

The control circuit 132 may include one or more processor(s) 134 and one or more memory device(s) 136. The one or more processor(s) 134 may include any suitable processing device, such as a microprocessor, microcontroller, integrated circuit, logic device, or other suitable processing device. The one or more memory device(s) 136 may include one or more computer-readable media, including, but not limited to, non-transitory computer-readable media, random access memory (RAM), read only memory (ROM), hard drives, flash drives, or other memory devices.

The one or more memory device(s) 136 may store information accessible by the one or more processor(s) 134, including computer-readable instructions 142 that can be executed by the one or more processor(s) 134. The instructions 142 can be any set of instructions that when executed by the one or more processor(s) 134, cause the one or more processor(s) 134 to perform operations. The instructions 142 may be software written in any suitable programming language or can be implemented in hardware. In some embodiments, the instructions 142 may be executed by the one or more processor(s) 134 to cause the one or more processor(s) to perform operations as described herein, and/or any other operations or functions of the controller. Additionally, and/or alternatively, the instructions 142 may be executed in logically and/or virtually separate threads on the processor(s) 134. The memory device(s) 136 can further store data 140 that can be accessed by the processor(s) 134.

The control circuit 132 can also include a communications interface 146 used to communicate, for example, with the components of the system 160.
The communications interface 146 may include any suitable components for interfacing with one or more communication network(s) 148, including for example, transmitters, receivers, ports, controllers, antennas, or other suitable components. The control circuit 132 may also be communication (e.g., via the communications interface 146) with the various components or devices of the system 160 described above and may selectively operate such components or devices in response to user input and feedback from these components. More specifically, for the embodiment depicted, the control circuit 132 can be configured to communicate through a communication network 148 through communications interface 146, such that the control circuit 132 may send or receive information and/or commands to or from the various components of the sensor assembly 100 wirelessly. It should be appreciated, however, that in other embodiments, the control circuit 132 may additionally, or alternatively, use a wired communication bus to communicate with various components or devices of the system 160.

The database(s) 150 may be any suitable databases (e.g., hierarchical databases, relational databases, non-relational databases, object oriented databases, and so forth) configured to store data relevant to the sensor assembly 100. In some embodiments, data stored in the database(s) 150 includes readings from the sensor assembly 100 (e.g., contact pressure readings and/or alternate readings of from the sensor assembly 100 regarding the target surface 154 of the component 152), contact pressure thresholds, inspection data, and so forth. Any suitable data relevant to the systems described herein may be stored in one or more databases 150. In some aspects, the data stored in the databases 150 is the same (at least in part) as the data 140 stored in the memory device(s) 136.

Various components of the system 160 are operatively coupled to the sensor assembly 100 over a communication network 148. The communication network 148 may be any suitable network or communication method such as, for example, a local area network (LAN), the Internet, wide area network (WAN), etc., communication link, other networks or communication channels with other devices and/or other such communications (not shown) or combination of two or more of such communication methods. There may be any combination of wired connections and/or wireless connections (e.g., Wi-Fi, Bluetooth, cellular, RF, and/or other such wireless communication) between elements of the sensor assembly 100.

FIG. 6 shows exemplary sensor elements 108 that can be incorporated into the sensor assembly 100, in accordance with some embodiments.

In some aspects, the first group of sensor elements 114 includes a high pitch sensor element 128. In other words, the first group of sensor elements 114 includes high pitch traces. The high pitch sensor element 128 generally includes at least one of a high pitch sense coil 115 or a high pitch interconnect 129. Generally, a sense coil 115 is able to detect a change in a magnetic field (e.g., a magnetic field created by a drive coil 113). As shown in FIG. 2, the first group of sensor elements 114 is in the form of eight radially spaced sense coils 115 printed onto the flexible substrate 105 of the flexible layer 104. It is generally contemplated that any alternate suitable high pitch sensor elements 128 may be used.

In some aspects, the second group of sensor elements 112 includes a low pitch sensor element 126. In other words, the second group of sensor elements 112 includes low pitch traces. The low pitch sensor element 126 generally includes at least one of a low pitch drive coil 113 or a low pitch interconnect 127. Generally, a drive coil 113 generates a magnetic field when current flows through the drive coil 113. As shown in FIG. 3, the second group of sensor elements 112 is in the form of a drive coil 113 printed onto the stretchable substrate 103 of the stretchable layer 102. It is generally contemplated that any alternate suitable low pitch sensor elements 126 may be used.

FIG. 7 shows various conformability features that can be included in the sensor assemblies described herein.

In some embodiments, the conformability features 200 include a plurality of cuts 206 formed in the flexible layers 104.

In some embodiments, the conformability feature 200 include one or more folds 208 formed in the flexible layers 104. In some aspects, the conformability feature 200 include a combination of cuts 206 and folds 208 in the flexible layers 104.

In some embodiments, the conformability feature 200 includes a deployable mechanism 210 operable to conform the sensor assembly 100 to a target surface 154.

In some embodiments, the sensor assembly 100 is implemented as a rollable sensor 212 to provide the conformability feature 200. The sensor assembly 100 may comprise a rollable sensor 212, such that the sensor assembly 100 is able to roll (e.g., for storage, insertion) and unroll (e.g., for use).

FIGS. 8A-8K show alternative configurations for the conformability feature 200 of the flexible layer 104 in the sensor assembly 100 of FIGS. 1A-1B. FIGS. 8A-8J show alternative configurations for the plurality of cuts 106 that are formed in the flexible layer 104. FIG. 8K shows a plurality of holes 214 formed in the flexible layer 104 in place of the plurality of cuts 106.

In FIGS. 8A-8D, the plurality of cuts 106 are formed in petal-shaped segments that provide flexibility and enable the sensor assembly 100 to wrap around curved surfaces in accordance with some embodiments.

In FIGS. 8E-8H, the plurality of cuts 106 are formed in tessellations (i.e., a repeating pattern of shapes) or geodesic shapes that form a geometric pattern that allow the sensor assembly 100 to bend and conform to various geometries in accordance with some embodiments.

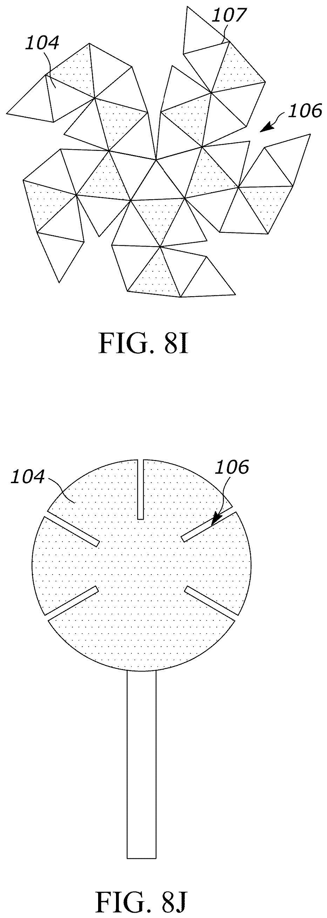

In FIG. 8I, the plurality of cuts 106 are incorporated with one or more folds 107 (e.g., kirigami) to enable the sensor assembly 100 to stretch and adapt to complex shapes.

In FIG. 8J, the plurality of cuts 106 are formed as radial cuts, in accordance with some embodiments.

In FIG. 8K, the flexible layer 104 includes a plurality of holes 214. The plurality of holes 214 can be arranged in groupings. As illustrated the plurality of holes 214 are arranged in lines. Groupings of the plurality of holes 214 can be strategically placed on the flexible layer 104, for example, in areas likely to see stresses due to bending or folding of the flexible layer 104 during use.

Those skilled in the art will recognize that a wide variety of other modifications, alterations, and combinations can also be made with respect to the above described embodiments without departing from the scope of the invention, and that such modifications, alterations, and combinations are to be viewed as being within the ambit of the inventive concept.

Further aspects of the disclosure are provided by the subject matter of the following clauses:
A sensor assembly comprising: at least one flexible layer including a flexible substrate having an elongation of break of greater than about 10 percent about at least one axis, the at least one flexible layer having a plurality of cuts formed therein; and at least one stretchable layer including a stretchable substrate having a modulus of less than about 60 megapascals (MPa) and an elongation of break of greater than about 25 percent about at least one axis.

The sensor assembly of any preceding clause, wherein the sensor assembly includes a plurality of sensor elements, the plurality of sensor elements including a first group of sensor elements printed on the flexible substrate and a second group of sensor elements printed on the stretchable substrate, wherein at least some of the plurality of sensor elements are disposed between the plurality of cuts of the at least one flexible layer.

The sensor assembly of any preceding clause, wherein the second group of sensor elements includes a low pitch sensor element.

The sensor assembly of any preceding clause, wherein the low pitch sensor element includes at least one of a low pitch drive coil or a low pitch interconnect.

The sensor assembly of any preceding clause, wherein the first group of sensor elements includes a high pitch sensor element.

The sensor assembly of any preceding clause, wherein the high pitch sensor element includes at least one of a high pitch sense coil or a high pitch interconnect.

The sensor assembly of any preceding clause, wherein the plurality of cuts in the at least one stretchable layer are radial cuts that extend inward from an edge of the flexible substrate towards a center of the flexible substrate.

The sensor assembly of any preceding clause, wherein the plurality of cuts in the at least one flexible layer are formed in a geometric pattern.

The senor assembly of any preceding clause, wherein the plurality of cuts in the at least one flexible layer form a repeating pattern of shapes.

The sensor assembly of any preceding clause, wherein the plurality of cuts in the at least one flexible layer are formed in petal-shaped segments.

The sensor assembly of any preceding clause, wherein the at least one flexible layer further includes at least one fold for conformability.

The sensor assembly of any preceding clause, wherein the sensor assembly is a rollable sensor.

The sensor assembly of any preceding clause, further comprising a deployable mechanism for deploying the sensor assembly to conform to a target surface.

The sensor assembly of any preceding clause, further comprising: an actuation layer including a stretchable substrate with at least one contact pressure actuator.

The sensor assembly of any preceding clause, wherein the at least one contact pressure actuator includes at least one of a microfluidics, a pneumatic array, a shape memory actuator, a multiplexed dielectric elastomer actuator, an electroactive polymer, a suction cup array, an electroadhesive pad, or a vacuum suction device.

The sensor assembly of any preceding clause, wherein the at least one contact pressure actuator comprises a trace formed from a shape memory alloy, the trace configured for sensing and pressure actuation.

The sensor assembly of any preceding clause, further comprising at least one pressure sensor configured to sense contact pressure of a target surface on the sensor assembly.

The sensor assembly of any preceding clause, further comprising a control circuit in communication with the at least one pressure sensor and the at least one contact pressure actuator, the control circuit configured to: receive data on the contact pressure from the at least one pressure sensor; and adjust the contact pressure via the at least one contact pressure actuator based on the data.

The sensor assembly of any preceding clause, wherein the control circuit is in communication with traces in at least one of a first group of sensor elements disposed on the flexible substrate or a second group of sensor elements disposed on the stretchable substrate, and wherein the control circuit is further configured to: receive signals from the traces in at least one of the first group of sensor elements or the second group of sensor elements; and adjust the contact pressure via the at least one contact pressure actuator based on the signals.

A sensor assembly comprising: at least one stretchable layer including a stretchable substrate; at least one flexible layer including a flexible substrate coupled to the at least one stretchable layer; an actuation layer coupled to the at least one stretchable layer and the at least one flexible layer, the actuation layer including at least one contact pressure actuator for adjusting contact pressure of a target surface on the sensor assembly; and a control circuit in communication with the at least one contact pressure actuator, the control circuit configured to receive information on the contact pressure of the target surface on the sensor assembly from a trace and to adjust the contact pressure of the target surface on the sensor assembly via the at least one contact pressure actuator based on the information.

The sensor assembly of any preceding clause, wherein the stretchable substrate has a modulus of less than about 60 megapascals (MPa) and an elongation of break of greater than about 25 percent about at least one axis; and wherein the flexible substrate has an elongation of break of greater than about 10 percent about at least one axis, the at least one flexible layer having a plurality of cuts formed therein.

The sensor assembly of any preceding clause, wherein the actuation layer comprises a stretchable substrate with a trace formed from an active material operable to perform sensing and adjust the contact pressure of the target surface on the sensor assembly.

The sensor assembly of any preceding clause, wherein the active material is a shape memory alloy.

The sensor assembly of any preceding clause, wherein the shape memory alloy is at least one of Nitinol or a copper-based shape memory alloy.

The sensor assembly of any preceding clause, wherein the at least one contact pressure actuator includes at least one of microfluidics, a pneumatic array, a multiplexed dielectric elastomer actuator, an electroactive polymer, a suction cup array, an electroadhesive pad, or a vacuum suction device.

A sensor assembly comprising: at least one flexible layer, the at least one flexible layer having an elongation of break of greater than about 10 percent, the at least one flexible layer having conformability features; a first group of sensor elements printed on the at least one flexible layer; at least one stretchable layer, the at least one stretchable layer made from one or more materials having a modulus of less than about 60 megapascals (MPa) and an elongation of break of greater than about 25 percent, the at least one stretchable layer including a low pitch sensor element; and a second group of sensor elements printed on the at least one stretchable layer; wherein the first group of sensor elements and the second group of sensor elements form a plurality of sensor elements; wherein at least some of the plurality of sensor elements are disposed between conformability features of the at least one flexible layer.

The sensor assembly of any preceding clause, wherein the conformability features include a plurality of cuts formed in the at least one flexible layer.

The sensor assembly of any preceding clause, wherein the conformability features include a combination of cuts and folds formed in the at least one flexible layer.

The sensor assembly of any preceding clause, wherein the conformability features include a deployable mechanism operable to conform the sensor assembly to a target surface.

The sensor assembly of any preceding clause, wherein the conformability features include one or more folds formed in the at least one flexible layer.

The sensor assembly of any preceding clause, wherein the conformability features include a rollable sensor.

A sensor assembly comprising: at least one flexible layer including a flexible substrate having an elongation of break of greater than about 10 percent about at least one axis, the at least one flexible layer having a plurality of cuts formed therein; and at least one stretchable layer including a stretchable substrate having a modulus of less than about 5 megapascals (MPa) and an elongation of break of greater than about 25 percent about at least one axis.

The sensor assembly of any preceding clause, wherein the sensor assembly includes a plurality of sensor elements, the plurality of sensor elements including a first group of sensor elements printed on the flexible substrate and a second group of sensor elements printed on the stretchable substrate, wherein at least some of the plurality of sensor elements are disposed between the plurality of cuts of the at least one flexible layer.

The sensor assembly of any preceding clause, wherein the second group of sensor elements includes a low pitch sensor element.

The sensor assembly of any preceding clause, wherein the low pitch sensor element includes at least one of a low pitch drive coil or a low pitch interconnect.

The sensor assembly of any preceding clause, wherein the first group of sensor elements includes a high pitch sensor element.

The sensor assembly of any preceding clause, wherein the high pitch sensor element includes at least one of a high pitch sense coil or a high pitch interconnect.

The sensor assembly of any preceding clause, wherein the plurality of cuts in the at least one stretchable layer are radial cuts that extend inward from an edge of the flexible substrate towards a center of the flexible substrate.

The sensor assembly of any preceding clause, wherein the plurality of cuts in the at least one flexible layer are formed in a geometric pattern.

The sensor assembly of any preceding clause, wherein the plurality of cuts in the at least one flexible layer form a repeating pattern of shapes.

The sensor assembly of any preceding clause, wherein the plurality of cuts in the at least one flexible layer are formed in petal-shaped segments.

The sensor assembly of any preceding clause, wherein the at least one flexible layer further includes at least one fold for conformability.

The sensor assembly of any preceding clause, wherein the sensor assembly is a rollable sensor.

The sensor assembly of any preceding clause, further comprising a deployable mechanism for deploying the sensor assembly to conform to a target surface.

The sensor assembly of any preceding clause, further comprising: an actuation layer including a stretchable substrate with at least one contact pressure actuator.

The sensor assembly of any preceding clause, wherein the at least one contact pressure actuator includes at least one of a microfluidics, a pneumatic array, a multiplexed dielectric elastomer actuator, an electroactive polymer, a suction cup array, an electroadhesive pad, or a vacuum suction device.

The sensor assembly of any preceding clause, wherein the at least one contact pressure actuator comprises a trace formed from a shape memory alloy, the trace configured for sensing and pressure actuation.

The sensor assembly of any preceding clause, further comprising at least one pressure sensor configured to sense contact pressure of a target surface on the sensor assembly.

The sensor assembly of any preceding clause, further comprising a control circuit in communication with the at least one pressure sensor and the at least one contact pressure actuator, the control circuit configured to: receive data on the contact pressure from the at least one pressure sensor; and adjust the contact pressure via the at least one contact pressure actuator based on the data.

The sensor assembly of any preceding clause, wherein the control circuit is in communication with traces in at least one of a first group of sensor elements disposed on the flexible substrate or a second group of sensor elements disposed on the stretchable substrate, and wherein the control circuit is further configured to: receive signals from the traces in at least one of the first group of sensor elements or the second group of sensor elements; and adjust the contact pressure via the at least one contact pressure actuator based on the signals.

A sensor assembly comprising: at least one stretchable layer including a stretchable substrate; at least one flexible layer including a flexible substrate coupled to the at least one stretchable layer; an actuation layer coupled to the at least one stretchable layer and the at least one flexible layer, the actuation layer including at least one contact pressure actuator for adjusting contact pressure of a target surface on the sensor assembly; and a control circuit in communication with the at least one contact pressure actuator, the control circuit configured to receive information on the contact pressure of the target surface on the sensor assembly from a trace and to adjust the contact pressure of the target surface on the sensor assembly via the at least one contact pressure actuator based on the information.

The sensor assembly of any preceding clause, wherein the stretchable substrate has a modulus of less than about 5 megapascals (MPa) and an elongation of break of greater than about 25 percent about at least one axis; and wherein the flexible substrate has an elongation of break of greater than about 10 percent about at least one axis, the at least one flexible layer having a plurality of cuts formed therein.

The sensor assembly of any preceding clause, wherein the actuation layer comprises a stretchable substrate with a trace formed from an active material operable to perform sensing and adjust the contact pressure of the target surface on the sensor assembly.

The sensor assembly of any preceding clause, wherein the active material is a shape memory alloy.

The sensor assembly of any preceding clause, wherein the shape memory alloy is at least one of Nitinol or a copper-based shape memory alloy.

The sensor assembly of any preceding clause, wherein the at least one contact pressure actuator includes at least one of a microfluidics, a pneumatic array, a multiplexed dielectric elastomer actuator, an electroactive polymer, a suction cup array, an electroadhesive pad, or a vacuum suction device.

A sensor assembly comprising: at least one flexible layer, the at least one flexible layer having an elongation of break of greater than about 10 percent, the at least one flexible layer having a conformability feature; a first group of sensor elements printed on the at least one flexible layer; at least one stretchable layer, the at least one stretchable layer made from one or more materials having a modulus of less than about 5 megapascals (MPa) and an elongation of break of greater than about 25 percent, the at least one stretchable layer including a low pitch sensor element; and a second group of sensor elements printed on the at least one stretchable layer; wherein the first group of sensor elements and the second group of sensor elements form a plurality of sensor elements; wherein at least some of the plurality of sensor elements are disposed between conformability features of the at least one flexible layer.

The sensor assembly of any preceding clause, wherein the conformability features include a plurality of cuts formed in the at least one flexible layer.

The sensor assembly of any preceding clause, wherein the conformability features include a combination of cuts and folds formed in the at least one flexible layer.

The sensor assembly of any preceding clause, wherein the conformability features include a deployable mechanism operable to conform the sensor assembly to a target surface.

The sensor assembly of any preceding clause, wherein the conformability features include one or more folds formed in the at least one flexible layer.

The sensor assembly of any preceding clause, wherein the conformability features include a rollable sensor.

A sensor assembly comprising: at least one flexible layer including a flexible substrate having an elongation of break of greater than about 10 percent about at least one axis, the at least one flexible layer having a plurality of cuts formed therein; and at least one stretchable layer including a stretchable substrate having a modulus of less than about 60 megapascals (MPa) and an elongation of break of greater than about 25 percent about at least one axis.

The sensor assembly of any preceding clause, wherein the sensor assembly includes a plurality of sensor elements, the plurality of sensor elements including a first group of sensor elements printed on the flexible substrate and a second group of sensor elements printed on the stretchable substrate, wherein at least some of the plurality of sensor elements are disposed between the plurality of cuts of the at least one flexible layer.

The sensor assembly of any preceding clause, wherein the second group of sensor elements includes a low pitch sensor element.

The sensor assembly of any preceding clause, wherein the first group of sensor elements includes a high pitch sensor element.

The sensor assembly of any preceding clause, wherein the plurality of cuts in the at least one flexible layer are radial cuts that extend inward from an edge of the flexible substrate towards a center of the flexible substrate.

The sensor assembly of any preceding clause, wherein the plurality of cuts in the at least one flexible layer are formed in a geometric pattern.

The sensor assembly of any preceding clause, wherein the plurality of cuts in the at least one flexible layer form a repeating pattern of shapes.

The sensor assembly of any preceding clause, further comprising a deployable mechanism for deploying the sensor assembly to conform to a target surface.

The sensor assembly of any preceding clause, further comprising: an actuation layer including a stretchable substrate with at least one contact pressure actuator.

The sensor assembly of any preceding clause, wherein the at least one contact pressure actuator includes at least one of microfluidics, a pneumatic array, a shape memory actuator, a multiplexed dielectric elastomer actuator, an electroactive polymer, a suction cup array, an electroadhesive pad, or a vacuum suction device.

The sensor assembly of any preceding clause, wherein the at least one contact pressure actuator comprises a trace formed from a shape memory alloy, the trace configured for sensing and pressure actuation.

The sensor assembly of any preceding clause, further comprising at least one pressure sensor configured to sense contact pressure of a target surface on the sensor assembly.

The sensor assembly of any preceding clause, further comprising a control circuit in communication with the at least one pressure sensor and the at least one contact pressure actuator, the control circuit configured to: receive data on the contact pressure from the at least one pressure sensor; and adjust the contact pressure via the at least one contact pressure actuator based on the data.

The sensor assembly of any preceding clause, wherein the control circuit is in communication with traces in at least one of a first group of sensor elements disposed on the flexible substrate or a second group of sensor elements disposed on the stretchable substrate, and wherein the control circuit is further configured to: receive signals from the traces in at least one of the first group of sensor elements or the second group of sensor elements; and adjust the contact pressure via the at least one contact pressure actuator based on the signals.

A sensor assembly comprising: at least one stretchable layer including a stretchable substrate; at least one flexible layer including a flexible substrate coupled to the at least one stretchable layer; an actuation layer coupled to the at least one stretchable layer and the at least one flexible layer, the actuation layer including at least one contact pressure actuator for adjusting contact pressure of a target surface on the sensor assembly; and a control circuit in communication with the at least one contact pressure actuator, the control circuit configured to receive information on the contact pressure of the target surface on the sensor assembly from a trace and to adjust the contact pressure of the target surface on the sensor assembly via the at least one contact pressure actuator based on the information.

The sensor assembly of any preceding clause, wherein the stretchable substrate has a modulus of less than about 60 megapascals (MPa) and an elongation of break of greater than about 25 percent about at least one axis; and wherein the flexible substrate has an elongation of break of greater than about 10 percent about at least one axis, the at least one flexible layer having a plurality of cuts formed therein.

The sensor assembly of any preceding clause, wherein the actuation layer comprises a stretchable substrate with a trace formed from an active material operable to perform sensing and adjust the contact pressure of the target surface on the sensor assembly.

The sensor assembly of any preceding clause, wherein the active material is a shape memory alloy.

A sensor assembly comprising: at least one flexible layer, the at least one flexible layer having an elongation of break of greater than about 10 percent, the at least one flexible layer having conformability features; a first group of sensor elements printed on the at least one flexible layer; at least one stretchable layer, the at least one stretchable layer made from one or more materials having a modulus of less than about 60 megapascals (MPa) and an elongation of break of greater than about 25 percent, the at least one stretchable layer including a low pitch sensor element; and a second group of sensor elements printed on the at least one stretchable layer; wherein the first group of sensor elements and the second group of sensor elements form a plurality of sensor elements; wherein at least some of the plurality of sensor elements are disposed between conformability features of the at least one flexible layer.

The sensor assembly of any preceding clause, wherein the conformability features include at least one of: a plurality of cuts formed in the at least one flexible layer; a combination of cuts and folds formed in the at least one flexible layer; a deployable mechanism operable to conform the sensor assembly to a target surface; a fold formed in the at least one flexible layer; or rollable sensor.

## Claims

1. A sensor assembly (100) comprising:
at least one flexible layer (104) including a flexible substrate (105) having an elongation of break of greater than about 10 percent about at least one axis, the at least one flexible layer (104) having a plurality of cuts (106, 206) formed therein; and
at least one stretchable layer (102) including a stretchable substrate (103) having a modulus of less than about 5 megapascals (MPa) and an elongation of break of greater than about 25 percent about at least one axis.

2. The sensor assembly (100) of claim 1, wherein the sensor assembly (100) includes a plurality of sensor elements (108), the plurality of sensor elements (108) including a first group of sensor elements (114) printed on the flexible substrate (105) and a second group of sensor elements (112) printed on the stretchable substrate (103), wherein at least some of the plurality of sensor elements (108) are disposed between the plurality of cuts (106, 206) of the at least one flexible layer (104).

3. The sensor assembly (100) of claim 2, wherein the second group of sensor elements (112) includes a low pitch sensor element (126).

4. The sensor assembly (100) of claims 2 or 3, wherein the first group of sensor elements (114) includes a high pitch sensor element (128).

5. The sensor assembly (100) of any of claims claim 1 to 4, wherein the plurality of cuts (106, 206) in the at least one flexible layer (104) are radial cuts that extend inward from an edge of the flexible substrate (105) towards a center of the flexible substrate (105).

6. The sensor assembly (100) of any of claims 1 to 5, wherein the plurality of cuts (106, 206) in the at least one flexible layer (104) are formed in a geometric pattern.

7. The sensor assembly (100) of any of claims 1 to 6, wherein the plurality of cuts (106, 206) in the at least one flexible layer (104) form a repeating pattern of shapes.

8. The sensor assembly (100) of any of claims 1 to 7, further comprising a deployable mechanism (122, 210) for deploying the sensor assembly (100) to conform to a target surface (154).

9. The sensor assembly (100) of any of claims 1 to 8, further comprising:
an actuation layer (116) including a stretchable substrate with at least one contact pressure actuator (118).

10. The sensor assembly (100) of claim 9, wherein the at least one contact pressure actuator (118) includes at least one of microfluidics, a pneumatic array, a shape memory actuator, a multiplexed dielectric elastomer actuator, an electroactive polymer, a suction cup array, an electroadhesive pad, or a vacuum suction device.

11. The sensor assembly (100) of claims 9 or 10, further comprising at least one pressure sensor (120) configured to sense contact pressure of a target surface (154) on the sensor assembly (100).

12. The sensor assembly (100) of claim 11, further comprising a control circuit (132) in communication with the at least one pressure sensor (120) and the at least one contact pressure actuator (118), the control circuit (132) configured to:
receive data on the contact pressure from the at least one pressure sensor (120); and
adjust the contact pressure via the at least one contact pressure actuator (118) based on the data.

13. A sensor assembly (100) of any of claims 9 to 12, further comprising:
a control circuit (132) in communication with the at least one contact pressure actuator (118), the control circuit (132) configured to receive information on a contact pressure of a target surface (154) on the sensor assembly (100) from a trace and to adjust the contact pressure of the target surface (154) on the sensor assembly (100) via the at least one contact pressure actuator (118) based on the information.

14. The sensor assembly (100) of claim 13, wherein the control circuit (132) is in communication with traces in at least one of a first group of sensor elements (114) disposed on the flexible substrate (105) or a second group of sensor elements (112) disposed on the stretchable substrate (103), and wherein the control circuit (132) is further configured to:
receive signals from the traces in at least one of the first group of sensor elements (114) or the second group of sensor elements (112); and
adjust the contact pressure via the at least one contact pressure actuator (118) based on the signals.

15. The sensor assembly (100) of claims 13 or 14, wherein the actuation layer (116) comprises a stretchable substrate (103) with a trace formed from an active material operable to perform sensing and adjust the contact pressure of the target surface (154) on the sensor assembly (100).
